# EUROPEAN PATENT SPECIFICATION

(11) **EP 1 728 085 B1**
(45) Date of publication and mention of the grant of the patent: **02.01.2008**
(21) Application number: 05718254.5
(22) Date of filing: 23.03.2005
(51) Int. Cl.: G01R 31/311

(54) **TESTING INTEGRATED CIRCUITS**
TESTEN INTEGRIERTER SCHALTUNGEN
TEST DE CIRCUITS INTEGRES

(30) Priority: 25.03.2004 GB 0406665
(43) Date of publication of application: 06.12.2006
(73) Proprietor: Melexis NV, 8900 Leper (BE)
(72) Inventor: BERGMANN, Peter,c/o Melexis GmbH, 99097 Erfurt (DE)
(74) Representative: Wilson Gunn
(86) International application number: PCT/IB2005/000755
(87) International publication number: WO 2005/093445

(56) References cited:
- US-A1- 2002 113 958
- US-A1- 2003 189 440
- US-B1- 6 285 200

## Description

The present invention relates to a method of testing integrated circuits and in particular to a method of testing integrated circuits which incorporate radiation sensing elements.

Integrated circuits may be tested by being inserted into a test socket, the test socket providing temporary electrical connections to the integrated circuit and applying suitable voltages, signals, loads, or monitors to the various connections. If the integrated circuit incorporates a sensing element, the testing may also include applying a suitable stimulus to the sensing element and monitoring the output voltages, signals or loads of the integrated circuit. If the sensing element is a radiation sensing element such as an optical sensor, the suitable stimulus is a controlled exposure to radiation.

Testing of this sort typically takes place after the integrated circuit has been packaged in a protective housing. The integrated circuits are picked up individually and inserted into the test socket by a test handler and retained in position, in the test socket by a plunger, the plunger applying pressure to the non contact side of the package.

Radiation sensing integrated circuits such as those adapted to detect visible or infra red radiation are housed in a package having a transparent opening or window by means of which such radiation may enter the package. When such packages are tested in the manner described above, if the radiation sensing capability is to be tested then it is necessary to expose the sensor to radiation through the window. If the package is very small then it is difficult to specifically adapt the plunger so that it does not cover the glass window and thus preclude testing of the radiation sensing capability c f the packaged integrated circuit.

After the completing the testing of an individual packaged integrated circuit, the plunger releases the package and moves away. The tested package is then removed from the test socket by the test handler and a new integrated circuit is then inserted into the socket. The plunger then moves in towards the new package to retain it in position for testing. The time taken to change between packages is called the index time and is typically less than 500 milliseconds. Due to the amount of movement made by the plunger during this time interval, and the resultant acceleration experienced by the plunger, it is not feasible to mount any testing electronics or any suitable radiation source on the plunger.

An Example of a prior art system is described in US 6,285,200, which discloses a test head for receiving a device and making electrical connection thereto, a handling apparatus for placing the device in and measuring the device from the test socket and a light source for illuminating the device whilst it is in the test socket. The light source is mounted separately to the test socket and is positioned such that it can shine through a passageway provided in the handling apparatus to illuminate the device when placed in the test socket.

US 2003/189440 discloses a system wherein a head chuck is provided which is operable to place a device into a test socket, for testing and wherein the head chuck incorporates an internal light source for illuminating the device during testing.

US 2002/0113958 describes providing a fixture upon a device for testing. The fixture acts to focus light upon various elements of the device during testing and also acts as a heat sink.

It is thus an object of the present invention to provide an apparatus and method of testing packaged radiation sensing integrated circuits which overcomes or alleviates the above problems.

According to a first aspect of the present invention there is provided an apparatus for testing a packaged integrated circuit of the type incorporating a radiation sensing element comprising: a load board provided with electrical circuitry for interfacing with the packaged integrated circuit to be tested; a test socket, said test socket being mounted on said load board and being adapted to provide electrical connections between said packaged integrated circuit and said load board; a plunger for retaining said packaged integrated circuit within said test socket; a radiation pathway provided in said plunger; and a radiation source, said pathway directing radiation emitted by said radiation source through said plunger to the radiation sensing element of said packaged integrated circuit characterised in that the radiation source is mounted on said load board adjacent to said test socket.

According to a second aspect of the present invention there is provided a method of testing packaged integrated circuits of the type incorporating a radiation sensing element comprising the following steps: inserting said packaged integrated circuit into a test socket, said test socket being mounted on a load board and being adapted to provide electrical connections between said packaged integrated circuit and said load board wherein said load board is provided with electrical circuitry for interfacing with the packaged integrated circuit to be tested; retaining the packaged integrated circuit in the test socket by applying pressure with a plunger; and directing radiation from a radiation source to said test socket through a radiation pathway provided it said plunger, thereby exposing the radiation sensing element to a suitable radiation signal emitted by the radiation source characterised in that the radiation source is mounted on said load board adjacent to said test socket

In this manner, there is provided an apparatus and a method by which a packaged radiation sensing integrated circuit can be exposed to a controlled quantity of radiation for testing purposes. Furthermore the method and apparatus is capable of being applied to conventional handing equipment with only minor modifications and is capable of dealing with small packaged radiation sensing integrated circuits.

Preferably, the radiation pathway is a generally U-shaped pathway through the plunger. Preferably a first end of the pathway is adjacent to the radiation source and a second end of the pathway is adjacent to the sensing element of the packaged integrated circuit when the plunger is used to retain the packaged integrated circuit within the test socket. Most preferably, said pathway is adapted for directing radiation from one end to its other end by the provision of radiation directing means.

In one preferred embodiment, the radiation directing means comprises two or more prisms mounted within the pathway. In an alternative preferred implementation the radiation directing means comprises one or more preferably a bundle of collimated optical fibres mounted within the pathway.

Preferably the radiation source is operative to emit a radiation pattern which is directed to the radiation sensing element of the packaged integrated circuit via the pathway. The radiation pattern may comprise variation in the intensity or frequency of radiation emitted by the radiation source either spatially or temporally. Most preferably, the spatial position of the radiation pattern on the light source can be varied to compensate for minor misalignment between the plunger, the radiation source and the packaged integrated circuit.

Preferably the area of the radiation source is equal to or greater than the cross-sectional area of the pathway. Preferably, the cross-sectional area of the pathway is greater than or equal to the area of the sensing element of the packaged integrated circuit. Most preferably, the shape of the radiation source, cross-section of the pathway and the sensing element of the packaged integrated circuit are similar.

In order that the invention is more clearly understood, it will now be described further herein, by way of example only and with reference to the following drawings in which:
- Figure 1: shows a section through a conventional testing apparatus;
- Figure 2: shows a testing apparatus in accordance with a first embodiment of the present invention; and
- Figure 3: shows a testing apparatus in accordance with a second embodiment of the present invention.

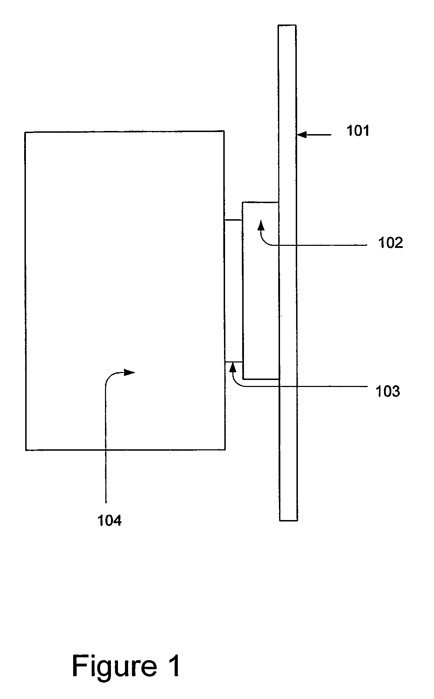

Referring now to figure 1, a conventional testing apparatus or test engine for a packaged integrated circuit comprises a load board 101 carrying a test socket 102 suitable for use with the particular packaged integrated circuit under test or device under test (DUT) 103. The DUT 103 is pushed into and retained in the socket 102 by pressure from a plunger 104. After completion of the desired tests on DUT 103, the plunger is retracted to allow the DUT 103 to be removed from the test socket and replaced by a new DUT 103. The plunger 104 is then extended once more to push the new DUT 103 into test socket 102. In this way, the apparatus can be used to test a succession of DUTs 103.

The load board 101 comprises circuitry adapted to interface with standard connections on the test socket 102 to test the specific requirements of the DUT 103. The load board 101 is specifically adapted to the DUT 103, and stores and runs device specific testing software. To reduce costs, and the time taken to change a testing apparatus from testing a first design of device to a second design of device, all the device specific aspects of the testing apparatus are provided wherever possible on the load board 101 and in the testing software. In this manner, the load board is replaced when the type of device to be tested changes.

When the DUT 103 is a packaged integrated circuit incorporating a radiation sensing element such as an optical or infra red sensing element, the DUT 103 is exposed to suitable radiation in order to test the response of the sensing element to stimulus. Typically such devices comprise a window or other opening in the package allowing the passage of radiation to the sensing element.

In order to reach the sensing element of DUT 103 when in the test socket 102, radiation must travel through, past or originate from within the plunger. As typically the plunger 104 retracts and extends very quickly, it is not feasible to provide a radiation source or the necessary control circuitry for a radiation source on the plunger 104. The radiation source is thus typically provide somewhere behind the plunger 104 and the plunger 104 is adapted to provide a hole through which radiation can pass to the sensing element or some form of recessed portion allowing radiation to travel past the edge of the plunger 104 to the sensing element. This reduces the grip of plunger 104 on DUT 103 and thus means that the DUT 103 is retained less securely in the test socket 102. Additionally, this requires careful alignment of the radiation source with the plunger 104 to ensure that radiation has an unobscured path to the sensing element of the DUT 103. Furthermore, as the radiation source is relatively remote, a relatively powerful radiation source must be used. The radiation source will typically also require a suitable focussing lens arrangement to provide a collimated beam of radiation that may pass through the hole in the plunger 104 or past the edge of the plunger 104 as appropriate.

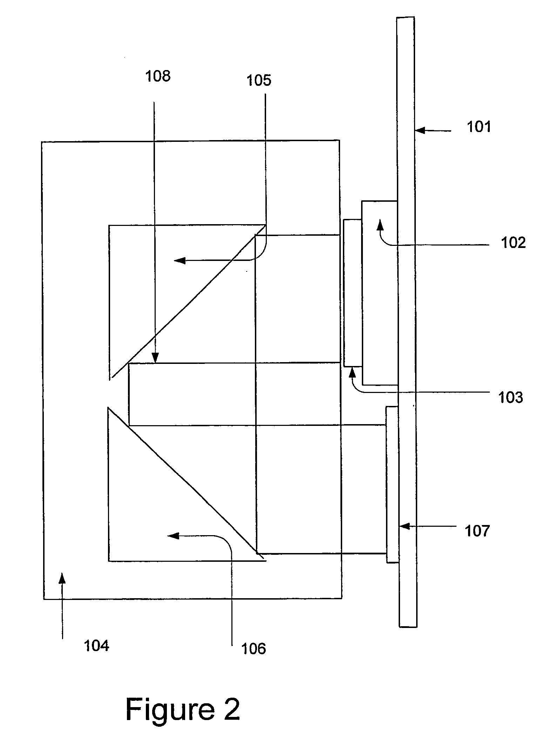

Figure 2 shows a testing apparatus or test engine according to a first embodiment of the present invention. As in the conventional testing apparatus shown in figure 1, the testing apparatus of figure 2 comprises a load board 101, a test socket 102, suitable for the device under test (DUT) 103, and a plunger 104. Additionally in the present invention, a radiation source 107 is provided on the load board 101 adjacent to the test socket 102.

The radiation source 107 generates radiation for testing the response to stimulus of the radiation sensing element of the DUT 103. In particular, the radiation source 107 is operative to generate a spatial radiation intensity pattern for testing the response of individual portions of the sensing element. In preferred embodiments, the radiation source 107 comprises a plurality of closely spaced individual radiation sources. It is of course possible that temporal radiation intensity patterns and temporal or spatial frequency variation patterns may additionally or alternatively be used for testing. The generation of said radiation patterns is controlled by device specific application software running on the test engine.

In order to allow the sensing element of the DUT 103 to be exposed to the radiation, a pathway 108 is provided through plunger 104. The pathway 108 has a U-Shape with the end of one side of the U being adjacent to the radiation source 107 and the other end of the U being adjacent to the sensing element of DUT 103. Radiation entering the pathway 108 from the radiation source 107, travels along the U and exits the other end of the U where it is then incident upon the radiation sensing element of DUT 103.

In order to direct radiation along the pathway 108 in the manner described above, in the embodiment of figure 2, prisms 105, 106 are mounted at the base of each side of the U so as to reflect incident light along the pathway 108. If care is taken to align the reflecting surfaces in this embodiment, the radiation incident upon the sensing element of DUT 103 is an accurate representation of the radiation pattern emitted by radiation source 107.

In order to ensure that radiation emitted from the radiation source is incident over the whole of the sensitive area of the sensing element, the radiation source 107 has an area at least as large as that of the cross-sectional area of the pathway 108 and is preferably larger. Similarly, the cross sectional area of the pathway 108 is at least as large as that of the sensing element and is preferably larger. This means that small misalignments in the position of the plunger 104 do not compromise the operation of the test apparatus. In order to operate with a misalignment, the radiation source 107 is adapted to be able to vary the spatial position of the whole or part of the radiation pattern in response to electrical signals received from the DUT 103 via the test socket 102 and load board 101.

In figure 2, the prisms 105, 106 are positioned so that they reflect radiation from an external surface. It is of course possible that the prisms 105, 106 could be repositioned so that reflection of radiation takes place from internal surfaces of the prisms 105, 106. As a further alternative, mirrors could be provided in the pathway 108 at the positions occupied by prisms 105, 106 in figure 2.

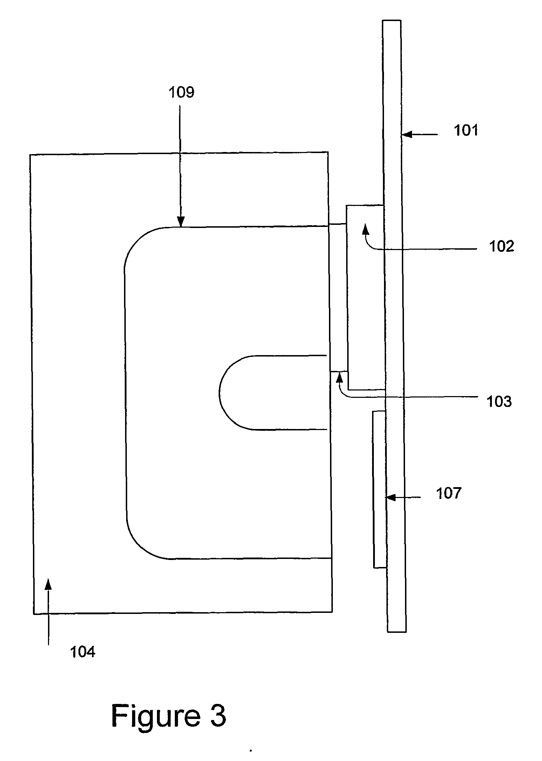

Referring now to figure 3, in an alternative embodiment, the prisms 105, 106 are omitted and the pathway 108 is filled by a bundle of collimated optical fibres 109. The number of individual optical fibres used depends on the resolution required in the radiation pattern emitted by radiation source 107 for testing and also the size of the incremental movements used to correct for minor misalignments of the plunger 104.

It is of course to be understood that the invention is not to be limited to the details of the above embodiments which are described by way of example only.

## Claims

1. An apparatus for testing a packaged integrated circuit (103) of the type incorporating a radiation sensing element comprising: a load board (101) prc vided with electrical circuitry for interfacing with the packaged integrated circuit (103) to be tested; a test socket (102), said test socket (102) being mounted on said load board (101) and being adapted to provide electrical connections between said packaged integrated circuit (103) and said load board (101); a plunger (104) for retaining said packaged integrated circuit (103) within said test socket (102); a radiation pathway provided in said plunger (104); and a radiation source (107), said pathway (108) directing radiation emitted by said radiation source, through said plunger (104) to the radiation sensing element of said packaged integrated circuit (103) **characterised in that** the radiation source (107) is mounted on said load board (101) adjacent to said test socket (102).

2. Ar apparatus as claimed in claim 1 wherein the radiation pathway (108) is a generally U-shaped pathway through the plunger (104).

3. An apparatus as claimed in claim 1 or claim 2 wherein a first end of the pathway (108) is adjacent to the radiation source (107) and a second end of the pathway (108) is adjacent to the sensing element of the packaged integrated circuit (103) when the plunger (104) is used to retain the packaged integrated circuit (103) within the test socket (102).

4. An apparatus as claimed in any preceding claim wherein said pathway (108) is adapted for directing radiation from one end to its other end by the pro vision of radiation directing means.

5. An apparatus as claimed in claim 4 wherein the radiation directing means comprises two or more prisms (105, 106) mounted within the pathway (108).

6. An apparatus as claimed in claim 4 wherein the radiation directing means comprises a bundle of collimated optical fibres (109) mounted within the pathway (108).

7. An apparatus as claimed in any preceding claim wherein the radiation source (107) is operative to emit a radiation pattern which is directed to the radiation sensing element of the packaged integrated circuit (103) via the pathway (108).

8. An apparatus as claimed in claim 7 wherein the radiation pattern comprises spatial and/or temporal variations in the intensity and/or frequency of radiation emitted by the radiation source (107).

9. An apparatus as claimed in claim 7 or claim 8 wherein the spatial position of the radiation pattern on the radiation source (107) can be varied to compensate for minor misalignment between the plunger (104), the radiation source (107) and the packaged integrated circuit (103).

10. An apparatus as claimed in any preceding claim wherein the area of the radiation source (107) is equal to or greater than the cross-sectional area of the pathway (108).

11. An apparatus as claimed in any preceding claim wherein the cross-sectional area of the pathway (108) is greater than or equal to the area of the sensing element of the packaged integrated circuit (103).

12. An apparatus as claimed in any preceding claim wherein the shape of the radiation source (107), cross-section of the pathway (108) and the sensing ele:nent of the packaged integrated circuit (103) are similar.

13. A method of testing packaged integrated circuits (103) of the type incorporating a radiation sensing element comprising the following steps: inserting said packaged integrated circuit (103) into a test socket (102), said test socket (102) being mounted on a load board (101) and being adapted to provide electrical connections between said packaged integrated circuit (103) and said load board (101) wherein said load board (101) is provided with electrical circuitry for interfacing with the packaged integrated circuit (103) to be tested; retaining the packaged integrated circuit (103) in the test socket (102) by applying pressure with a plunger (104); and directing radiation from a radiation source (107) to said test socket (102) through a radiation pathway (108) provided in said plunger (104), thereby exposing the radiation sensing element to a suitable radiation signal emitted by the radiation source **characterised in that** the radiation source (107) is mounted on said load board (101) adjacent to said test socket (102).

14. A method as claimed in claim 13 implemented using the apparatus of claims 1 to 12.

## Patentansprüche

1. Apparat zum Testen einer verpackten integrierten Schaltung (103) des Typs, welcher einen Strahlungsmessfühler aufnimmt, mit: einer Bestückungsplatine (101), welche mit einer elektrischen Schaltung zum Anschließen einer verpackten integrierten Schaltung (103) ausgestattet ist, welche getestet werden soll; einer Testkupplung (102), wobei die genannte Testkupplung (102) auf der genannten Bestückungsplatine (101) montiert und dazu angepasst ist, elektrische Verbindungen zwischen der genannten verpackten integrierten Schaltung (103) und der genannten Bestückungsplatine (101) vorzusehen; einem Kolben (104) zum Festhalten der genannten verpackten integrierten Schaltung (103) in der genannten Testkupplung (102); einer Strahlungsdurchgangsbahn, welche in dem genannten Kolben (104) vorgesehen ist; und einer Strahlungsquelle (107), wobei die Durchgangsbahn (108) Strahlung, welche von der genannten Strahlungsquelle emittiert wird, durch den genannten Kolben (104) zu dem Strahlungsmessfühler der genannten verpackten integrierten Schaltung (103) führt, **dadurch gekennzeichnet, dass** die Strahlungsquelle (107) auf der Bestückungsplatine (101) benachbart der genannten Testkupplung (102) montiert ist.

2. Apparat nach Anspruch 1, bei welchem die Strahlungsdurchgangsbahn (108) eine im Wesentlichen U-förmige Durchgangsbahn durch den Kolben (104) ist.

3. Apparat nach Anspruch 1 oder 2, bei welchem ein erstes Ende der Durchgangsbahn (108) benachbart der Strahlungsquelle (107) und ein zweites Ende der Durchgangsbahn (108) benachbart dem Messfühler der verpackten integrierten Schaltung (103) ist, wenn der Kolben (104) benutzt wird, um die verpackte integrierte Schaltung (103) innerhalb der Testkupplung (102) zu halten.

4. Apparat nach einem der vorgehenden Ansprüche, bei welchem die genannte Durchgangsbahn (108) dazu angepasst ist, um Strahlung von einem Ende zu ihrem anderen Ende durch Bereitstellung von Strahlungsführungsmitteln zu führen.

5. Apparat nach Anspruch 4, bei welchem die Strahlungsführungsmittel zwei oder mehr Prismen (105, 106) aufweisen, welche innerhalb der Durchgangsbahn (108) montiert sind.

6. Apparat nach Anspruch 4, bei welchem die Strahlungsführungsmittel ein Bündel von kollimierten optischen Fasern (109) aufweist, welche innerhalb der Durchgangsbahn (108) montiert sind.

7. Apparat nach einem der vorhergehenden Ansprüche, bei welchem die Strahlungsquelle (107) im Betrieb ein Strahlungsmuster emittiert, welches zu dem Strahlungsmessfühler der verpackten integrierten Schaltung (103) über die Durchgangsbahn (108) geführt wird.

8. Apparat nach Anspruch 7, bei welchem das Strahlungsmuster räumliche und/oder zeitliche Variationen in der Intensität und/oder Frequenz der Strahlung, welche von der Strahlungsquelle (107) emittiert wird, aufweist.

9. Apparat nach Anspruch 7 oder 8, bei welchem die räumliche Position des Strahlungsmusters an der Strahlungsquelle (107) variiert werden kann, um geringere Fehlausrichtungen zwischen dem Kolben (104), der Strahlungsquelle (107) und der verpackten integrierten Schaltung (103) zu kompensieren.

10. Apparat nach einem der vorgehenden Ansprüche, bei welchem die Fläche der Strahlungsquelle (107) gleich oder größer ist als die Querschnittsfläche der Durchgangsbahn (108).

11. Apparat nach einem der vorhergehenden Ansprüche, bei welchem die Querschnittsfläche der Durchgangsbahn (108) größer oder gleich der Fläche des Messfühlers der verpackten integrierten Schaltung (103) ist.

12. Apparat nach einem der vorhergehenden Ansprüche, bei welchem die Gestalt der Strahlungsquelle (107), der Querschnitt der Durchgangsbahn (108) und des Messfühlers der verpackten integrierten Schaltung (103) ähnlich sind.

13. Verfahren zum Testen von verpackten integrierten Schaltungen (103) des Typs, welcher einen Strahlungsmessfühler aufnimmt, mit den folgenden Schritten: Einsetzen der genannten verpackten integrierten Schaltung (103) in eine Testkupplung (102), wobei die genannte Testkupplung (102) auf einer Bestückungsplatine (101) montiert und dazu angepasst ist elektrische Verbindungen zwischen der genannten verpackten integrierten Schaltung (103) und der genannten Bestückungsplatine (101) vorzusehen, wobei die genannte Bestückungsplatine mit einer elektrischen Schaltung zum Anschließen an die verpackte integrierte Schaltung (103) ausgestattet ist, welche getestet werden soll; Festhalten der verpackten integrierten Schaltung (103) in der Testkupplung (102) durch Anwenden von Druck mit einem Kolben (104); und Führen von Strahlung von einer Strahlungsquelle (107) zu der genannten Testkupplung (102) durch eine Strahlungsdurchgangsbahn (108), welche in dem genannten Kolben (104) vorgesehen ist, wodurch der Strahlungsmessfühler einem geeigneten Strahlungssignal ausgesetzt wird, welches von der Strahlungsquelle emittiert wird, **dadurch gekennzeichnet, dass** die Strahlungsquelle (107) auf der Bestückungsplatine (101) benachbart der genannten Testkupplung (102) montiert wird.

14. Verfahren nach Anspruch 13, ausgeführt unter Verwendung des Apparats nach den Ansprüchen 1 bis 12.

## Revendications

1. Appareil d'essai pour un circuit intégré sous boîtier (103) du type comprenant un élément sensible au rayonnement, comprenant : une plaquette de charge (101) pourvue de circuits électriques pour un raccordement au circuit intégré sous boîtier (103) à contrôler ; un socle d'essai (102), ledit socle d'essai (102) étant monté sur ladite plaquette de charge (101) et étant propre à assurer les connexions électriques entre ledit circuit intégré sous boîtier (103) et ladite plaquette de charge (101) ; un poussoir (104) pour retenir ledit circuit intégré sous boîtier (103) à l'intérieur dudit socle d'essai (102) ; un chemin de rayonnement prévu dans ledit poussoir (104) ; et une source de rayonnement (107), ledit chemin (108) dirigeant le rayonnement émis par ladite source de rayonnement, à travers ledit poussoir (104) jusqu'à l'élément sensible au rayonnement dudit circuit intégré sous boîtier (103), **caractérisé en ce que** la source de rayonnement (107) est montée sur ladite plaquette de charge (101) de manière adjacente audit socle d'essai (102).

2. Appareil selon la revendication 1, dans lequel le chemin de rayonnement (108) est un chemin globalement en forme de U à travers le poussoir (104).

3. Appareil selon la revendication 1 ou 2, dans lequel une première extrémité du chemin (108) est adjacente à la source de rayonnement (107), et une seconde extrémité du chemin (108) est adjacente à l'élément sensible du circuit intégré sous boîtier (103) lorsque le poussoir (104) est utilisé pour retenir le circuit intégré sous boîtier (103) à l'intérieur du socle d'essai (102).

4. Appareil selon l'une quelconque des revendications précédentes, dans lequel ledit chemin (108) est propre à diriger un rayonnement depuis une extrémité jusqu'à son autre extrémité, du fait de la présence de moyens d'orientation de rayonnement.

5. Appareil selon la revendication 4, dans lequel les moyens d'orientation de rayonnement comprennent deux prismes (105, 106) ou davantage, montés dans le chemin (108).

6. Appareil selon la revendication 4, dans lequel les moyens d'orientation de rayonnement comprennent un faisceau de fibres optiques collimatées (109) monté dans le chemin (108).

7. Appareil selon l'une quelconque des revendications précédentes, dans lequel la source de rayonnement (107) est prévue pour une émission selon un diagramme de rayonnement, qui est dirigé vers l'élément sensible au rayonnement du circuit intégré sous boîtier (103) par l'intermédiaire du chemin (108).

8. Appareil selon la revendication 7, dans lequel le diagramme de rayonnement comprend des variations spatiales et/ou temporelles de l'intensité et/ou de la fréquence du rayonnement émis par la source de rayonnement (107).

9. Appareil selon la revendication 7 ou la revendication 8, dans lequel la position spatiale du diagramme de rayonnement sur la source de rayonnement (107) peut être modifiée afin de compenser un défaut mineur d'alignement entre le poussoir (104), la source de rayonnement (107) et le circuit intégré sous boîtier (103).

10. Appareil selon l'une quelconque des revendications précédentes, dans lequel l'aire de la source de rayonnement (107) est égale ou supérieure à l'aire de la section transversale du chemin (108).

11. Appareil selon l'une quelconque des revendications précédentes, dans lequel l'aire de la section transversale du chemin (108) est supérieure ou égale à l'aire de l'élément sensible du circuit intégré sous boîtier (103).

12. Appareil selon l'une quelconque des revendications précédentes, dans lequel la forme de la source de rayonnement (107), la section transversale du chemin (108) et de l'élément sensible du circuit intégré sous boîtier (103) sont similaires.

13. Procédé de contrôle de circuits intégrés sous boîtier (103) du type comprenant un élément sensible au rayonnement, comprenant les étapes suivantes : l'insertion dudit circuit intégré sous boîtier (103) dans un socle d'essai (102), ledit socle d'essai (102) étant monté sur une plaquette de charge (101) et étant propre à assurer des connexions électriques entre ledit circuit intégré sous boîtier (103) et ladite plaquette de charge (101), ladite plaquette de charge (101) étant pourvue de circuits électriques pour un raccordement au circuit intégré sous boîtier (103) à contrôler ; la retenue du circuit intégré sous boîtier (103) dans le socle d'essai (102) en appliquant une pression par un poussoir (104) ; et l'orientation d'un rayonnement provenant d'une source de rayonnement (107) vers ledit socle d'essai (102) par l'intermédiaire d'un chemin de rayonnement (108) prévu dans ledit poussoir (104), pour ainsi exposer l'élément sensible au rayonnement à un signal de rayonnement approprié émis par la source de rayonnement, **caractérisé en ce que** la source de rayonnement (107) est montée sur ladite plaquette de charge (101) de manière adjacente audit socle d'essai (102).

14. Procédé selon la revendication 13, mis en oeuvre au moyen de l'appareil selon les revendications 1 à 12.
